(19) Europäisches Patentamt
European Patent Office
Office européen des brevets

(11) **EP 2 847 603 B1**

(12) **FASCICULE DE BREVET EUROPEEN**

(45) Date de publication et mention de la délivrance du brevet:
**14.08.2019 Bulletin 2019/33**

(21) Numéro de dépôt: **13727253.0**

(22) Date de dépôt: **03.05.2013**

(51) Int Cl.:
*G01R 31/382* *(2019.01)*  *G01R 31/3842* *(2019.01)*
*G01R 31/396* *(2019.01)*  *G01R 31/36* *(2019.01)*

(86) Numéro de dépôt international:
**PCT/FR2013/050994**

(87) Numéro de publication internationale:
**WO 2013/167833 (14.11.2013 Gazette 2013/46)**

(54) **ESTIMATION DE L'ETAT DE CHARGE D'UNE BATTERIE**

SCHÄTZUNG DES LADEZUSTANDS EINER BATTERIE

ESTIMATING THE STATE OF CHARGE OF A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.05.2012 FR 1254330**

(43) Date de publication de la demande:
**18.03.2015 Bulletin 2015/12**

(73) Titulaire: **Renault S.A.S.**
**92100 Boulogne-Billancourt (FR)**

(72) Inventeurs:
• **DRIEMEYER-FRANCO, Ana-Lucia**
**F-78180 Montigny-le-bretonneux (FR)**
• **GAGNEUR, Laurent**
**F-69006 Lyon (FR)**
• **LUCEA, Marc**
**F-92100 Boulogne-billancourt (FR)**

(56) Documents cités:
**WO-A2-2011/079977     US-A1- 2011 187 378**

EP 2 847 603 B1

**Description**

La présente invention concerne une méthode et un dispositif pour l'estimation de l'état de charge d'une batterie comportant une pluralité de cellules électrochimiques connectées en série.

Dans le domaine non limitatif des véhicules électriques et hybrides, l'un des principaux enjeux des systèmes de gestion des batteries de traction est l'estimation de l'état de charge de la batterie, encore appelé SOC (initiales anglo-saxonnes mises pour State of Charge). Cette information est affichée au niveau du tableau de bord, sous forme d'une « jauge batterie », et permet au conducteur de connaître l'autonomie kilométrique restante. L'autonomie d'un véhicule électrique étant très inférieure à celle d'un véhicule thermique, il est important de rassurer le conducteur en lui fournissant l'information la plus fiable possible. Des erreurs d'estimation de la jauge batterie peuvent en effet amener le conducteur à se retrouver dans des situations désagréables (panne sèche), voire dangereuses (manque de puissance pendant un dépassement).

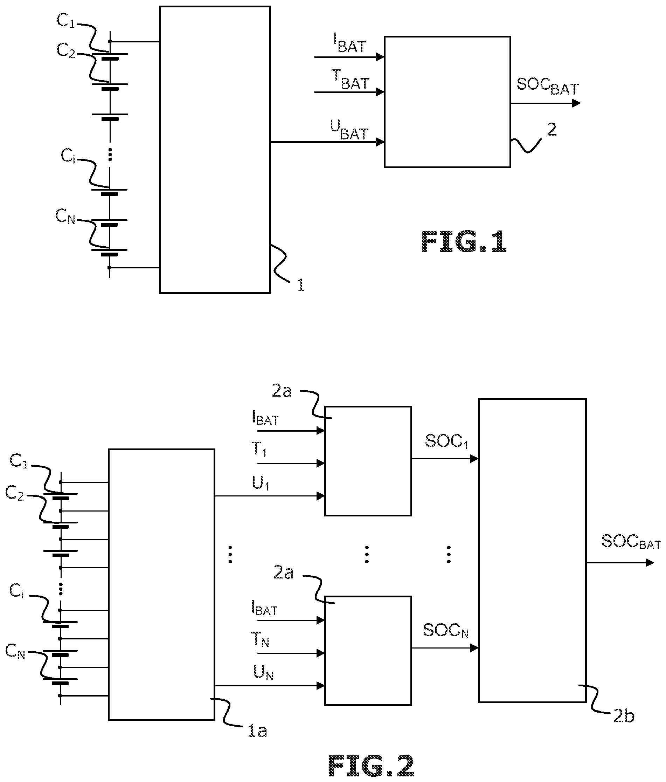

Aujourd'hui, comme illustré schématiquement sur la figure 1, l'état de charge $SOC_{BAT}$ d'une batterie comportant N cellules électrochimiques $C_i$ connectées en série est estimé classiquement à partir de mesures relatives à la batterie prise dans sa globalité. Ainsi, un premier équipement 1 mesure la tension totale $U_{BAT}$ de la batterie, prise aux bornes de l'ensemble des cellules en série, et des capteurs de courant et de température (non représentés) délivrent respectivement le courant $I_{BAT}$ traversant la batterie et la température $T_{BAT}$ de la batterie. A partir de ces trois mesures, un bloc logiciel 2 calcule une estimation de l'état de charge $SOC_{BAT}$ en utilisant une méthode classique telle qu'une méthode ampère-heure-métrique, ou encore une modélisation du type filtrage de Kalman. Une telle estimation basée sur des mesures globales correspond ainsi grossièrement à une moyenne de l'état de charge des cellules.

Or, les cellules électrochimiques constitutives de la batterie ont, de par leur construction, des caractéristiques différentes les unes des autres en termes de dispersion de leur capacité et de leur résistance interne, et subissent par ailleurs des variations de température différentes dues à leur emplacement dans la batterie. En conséquence, ces cellules auront forcement des états de charge différents les unes des autres et la batterie sera en déséquilibre. Quand cela a lieu, la plage d'utilisation de la batterie est imposée par la cellule la plus chargée et par la cellule la moins chargée. Dans ce cas, l'estimation basée sur des mesures globales est fausse.

D'autres dispositifs d'estimation envisagés préconisent d'estimer l'état de charge de chaque cellule individuellement, pour en déduire une valeur d'état de charge pour la batterie, en prenant en compte le déséquilibre des cellules. Un tel dispositif, représenté schématiquement sur la figure 2, comporte idéalement un premier équipement 1a mesurant simultanément les tensions $U_1$ à $U_N$ aux bornes de chaque cellule $C_i$ composant la batterie, un capteur de courant (non représenté) délivrant respectivement le courant $I_{BAT}$ traversant les N cellules de la batterie et des capteurs de température (non représentés) fournissant la température $T_i$ de chaque cellule $C_i$ composant la batterie. A partir de chaque mesure $U_i$, $T_i$ et $I_{BAT}$, N blocs logiciels 2a calculent une estimation de l'état de charge $SOC_i$ de chaque cellule $C_i$, en utilisant une méthode classique telle qu'une méthode ampère-heure-métrique, ou encore une modélisation du type filtrage de Kalman telle que celle décrite dans le document US 7, 315, 789. L'état de charge $SOC_{BAT}$ de la batterie est alors estimé par un module de calcul 2b à partir des N états de charge délivrés $SOC_i$ par les blocs logiciels 2a. Ces dispositifs sont certes plus précis, mais aussi plus chers et plus complexes d'un point de vue logiciel. Ils nécessitent des mesures de la tension aux bornes de chacune des cellules composant la batterie et des modèles sophistiqués pour décrire le comportement de chaque cellule (filtre de Kalman notamment). Dans le cas d'une batterie haute tension, telles que celles utilisées pour un véhicule électrique, le grand nombre de cellules élémentaires (96 bi-cellules dans les batteries actuelles) rend le coût du dispositif important. La demande WO2011/079977 présente les mêmes inconvénients.

La présente invention a pour but de pallier les inconvénients de l'art antérieur en proposant à moindre coût une méthode d'estimation précise de l'état de charge d'une batterie prenant en compte le déséquilibre des cellules.

Pour ce faire, la présente invention a pour objet une méthode d'estimation de l'état de charge d'une batterie comportant plusieurs cellules électrochimiques connectées en série, la tension aux bornes de la batterie correspondant à la somme des tensions aux bornes de chaque cellule appelées tensions de cellule, caractérisée en ce qu'elle comporte :

- une étape de détermination à un instant donné de la tension de cellule minimum et de la tension de cellule maximum parmi lesdites tensions de cellule;

- une étape de calcul d'une grandeur physique dont dépend directement ou indirectement l'état de charge de la batterie, ladite grandeur physique dépendant analytiquement directement ou indirectement de ladite tension de cellule minimum et de ladite tension de cellule maximum selon une équation incluant des éléments de pondération assurant que le poids associé à la tension de cellule maximum augmente lorsque l'état de charge de la cellule associée augmente, et le poids associé à la tension de cellule minimum augmente lorsque l'état de charge de la cellule associée diminue.

Selon d'autres caractéristiques possibles de l'invention :

- ladite grandeur physique est une tension moyenne pondérée dépendant analytiquement de ladite tension de cellule minimum et de ladite tension de cellule maximum selon l'équation suivante :

$$U_{mp}(k) = \frac{V_{seuil\,haut}U_{Cmin}(k) - V_{seuil\,bas}U_{Cmax}(k)}{\left(V_{seuil\,haut} - V_{seuil\,bas}\right) - \left(U_{Cmax}(k) - U_{Cmin}(k)\right)}$$

où $U_{Cmin}(k)$ et $U_{Cmax}(k)$ sont respectivement des échantillons de la tension de cellule minimum et la tension de cellule maximum à l'instant donné k, $V_{seuil\,bas}$ est un seuil de tension minimum d'utilisation prédéterminé correspondant à un état de charge minimum de la cellule associée et $V_{seuil\,haut}$ est un seuil de tension maximum d'utilisation prédéterminé correspondant à un état de charge maximum de la cellule associée.

- la méthode d'estimation peut comporter alors en outre une étape d'estimation de l'état de charge de la batterie à partir de ladite tension moyenne, d'une mesure du courant traversant les cellules audit instant donné, et d'une mesure de température de la batterie audit instant donné. L'étape d'estimation comprend par exemple un filtrage de type Kalman.

- En variante, la méthode d'estimation peut comporter en outre : une première estimation de l'état de charge $SOC_{Cmin}(k)$ de la cellule associée à la tension de cellule minimum à partir de ladite tension de cellule minimum, d'une mesure du courant traversant les cellules audit instant donné, et d'une première mesure de température audit instant donné ; et une deuxième estimation de l'état de charge $SOC_{Cmax}(k)$ de la cellule associée à la tension de cellule maximum à partir de ladite tension de cellule maximum, de ladite mesure de courant traversant les cellules audit instant donné, et d'une deuxième mesure de température audit instant donné ; ladite grandeur physique étant directement l'état de charge de la batterie audit instant donné, calculé selon l'équation

$$SOC_{BAT}(k) = \frac{SOC_{Cmin}(k)}{1 - \left(SOC_{Cmax}(k) - SOC_{Cmin}(k)\right)}$$

- Les première et deuxième estimations comprennent un filtrage de type Kalman.

- Les première et deuxième mesures de température sont une même mesure représentative de la température de la batterie.

- En variante, les première et deuxième mesures de température sont deux mesures distinctes prises respectivement au voisinage de la cellule associée à la tension de cellule minimum et au voisinage de la cellule associée à la tension de cellule maximum.

La présente invention a également pour objet un dispositif d'estimation de l'état de charge d'une batterie comportant plusieurs cellules électrochimiques connectées en série, la tension aux bornes de la batterie correspondant à la somme des tensions aux bornes de chaque cellule appelées tensions de cellule, caractérisé en ce qu'il comporte :

- un moyen de détermination à un instant donné de la tension de cellule minimum et de la tension de cellule maximum parmi lesdites tensions de cellule;

- des moyens de calcul d'une grandeur physique dont dépend directement ou indirectement l'état de charge de la batterie, ladite grandeur physique dépendant analytiquement directement ou indirectement de ladite tension de cellule minimum et de ladite tension de cellule maximum selon une équation incluant des éléments de pondération assurant que le poids associé à la tension de cellule maximum augmente lorsque l'état de charge de la cellule associée augmente, et le poids associé à la tension de cellule minimum augmente lorsque l'état de charge de la cellule associée diminue.

Le moyen de détermination est de préférence un composant analogique doté d'une fonction MIN-MAX.
L'invention et les avantages qu'elle procure seront mieux compris au vu de la description suivante faite en référence aux figure annexées, dans lesquelles :

- la figure 1 illustre schématiquement un dispositif pour l'estimation de l'état de charge d'une batterie à partir de mesures relatives à la batterie prise dans sa globalité, conformément à une méthode connue ;
- la figure 2 représente schématiquement un dispositif pour l'estimation de l'état de charge d'une batterie à partir de mesures de tensions faites sur chaque cellule composant la batterie ;
- la figure 3 illustre schématiquement un premier dispositif mettant en oeuvre la méthode d'estimation de l'état de charge d'une batterie conforme à l'invention ;
- la figure 4 représente une modélisation du comportement électrique d'une batterie ;
- la figure 5 donne un exemple d'estimation de l'état de charge d'une batterie obtenue avec le dispositif de la figure 3 ;
- la figure 6 illustre schématiquement un deuxième dispositif mettant en oeuvre la méthode d'estimation de l'état de charge d'une batterie conforme à l'invention ;
- la figure 7 donne un exemple d'estimation de l'état de charge d'une batterie obtenue avec le dispositif de la figure 6.

Dans la suite, on considère une batterie comportant N cellules électrochimiques $C_1$ à $C_N$ connectées en série. En fonctionnement, les N cellules sont ainsi parcourues par un même courant $I_{BAT}$, et la tension UBAT aux bornes de la batterie correspond à chaque instant à la somme des N tensions $U_1$ à $U_N$ prises aux bornes des N cellules.

Comme cela a été indiqué précédemment, les solutions de l'art antérieur fondent l'estimation de l'état de charge d'une telle batterie soit, sur une mesure de la tension globale $U_{BAT}$ aux bornes de l'ensemble des cellules, ce qui rend l'estimation peu précise, soit sur N mesures correspondant aux N tensions $U_1$ à $U_N$ aux bornes des N cellules, appelées dans la suite tensions de cellule, ce qui a l'avantage d'augmenter la précision de l'estimation, mais au prix d'une puissance de calcul importante.

Les recherches menées dans le cadre de la présente invention ont permis de démontrer qu'une estimation au moins aussi précise que celle obtenue avec le dispositif de la figure 2 pouvait être obtenue en s'intéressant non pas à l'ensemble des N tensions de cellule, mais uniquement à deux valeurs particulières de ces tensions de cellule à un instant donné, l'une correspondant à la valeur minimum sur l'ensemble des tensions de cellule, appelée tension de cellule minimum, l'autre correspondant à la valeur maximum sur l'ensemble des tensions de cellule, appelée tension de cellule maximum, ces deux valeurs étant notées respectivement $U_{Cmin}$ et $U_{Cmax}$ dans la suite.

Comme cela va être explicité plus en détail dans la suite de l'exposé, il est en effet possible de définir une grandeur physique dont dépend directement ou indirectement l'état de charge $SOC_{BAT}$ de la batterie, cette grandeur physique dépendant elle-même analytiquement directement ou indirectement de la tension de cellule minimum $U_{Cmin}$ et de la tension de cellule maximum $U_{Cmax}$ selon une équation incluant des éléments de pondération assurant que le poids associé à la tension de cellule maximum $U_{Cmax}$ augmente lorsque l'état de charge de la cellule associée augmente, et le poids associé à la tension de cellule minimum $U_{Cmin}$ augmente lorsque l'état de charge de la cellule associée diminue.

Plus précisément, on doit s'assurer que le poids associé à la tension de cellule maximum $U_{Cmax}$ est maximum lorsque cette tension $U_{Cmax}$ est au voisinage d'un seuil d'utilisation maximum prédéterminé correspondant à un état de charge maximum (100%) de la cellule associée, et le poids associé à la tension de cellule minimum $U_{Cmin}$ est maximum lorsque cette tension $U_{Cmin}$ est au voisinage d'un seuil d'utilisation minimum prédéterminé correspondant à un état de charge minimum (0%) de la cellule associée. Entre les deux, la variation de la grandeur physique doit être continue et sans variations abruptes.

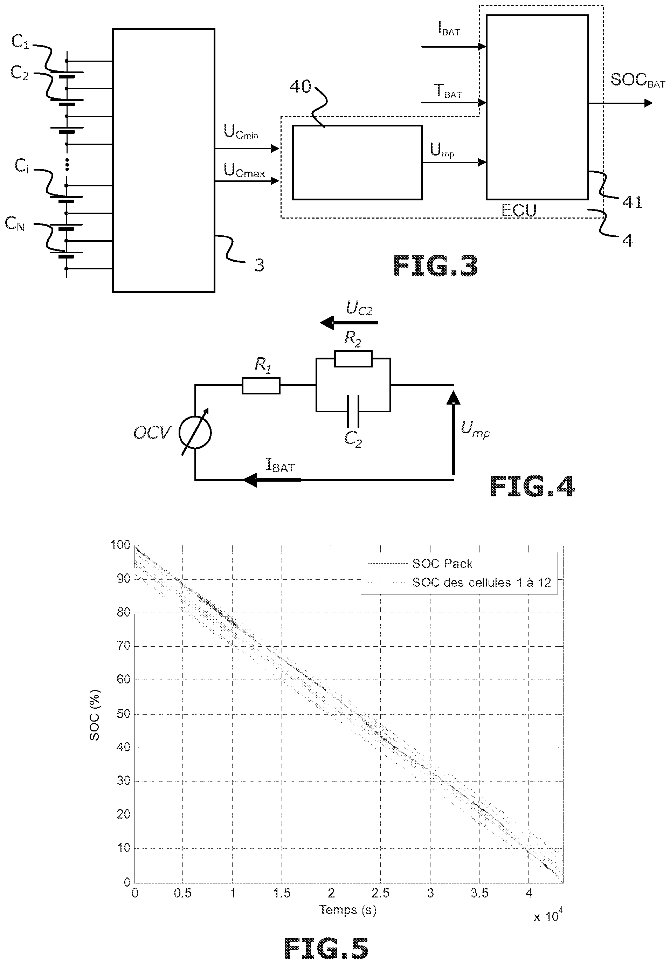

Selon une première possibilité dont la mise en oeuvre va être décrite en référence à la figure 3, la grandeur physique considérée est une tension moyenne pondérée $U_{mp}$ reliée analytiquement à la tension de cellule minimum $U_{Cmin}$ et de la tension de cellule maximum $U_{Cmax}$ selon l'équation :

$$U_{mp}(k) = \frac{V_{seuil\ haut} U_{Cmin}(k) - V_{seuil\ bas} U_{Cmax}(k)}{\left(V_{seuil\ haut} - V_{seuil\ bas}\right) - \left(U_{Cmax}(k) - U_{Cmin}(k)\right)}$$

dans laquelle $U_{mp}(k)$), $U_{Cmin}(k)$ et $U_{Cmax}(k)$ sont respectivement des échantillons de la tension moyenne pondérée, de la tension de cellule minimum et la tension de cellule maximum à un instant donné k, $V_{seuil\ bas}$ est le seuil d'utilisation minimum (valeur de tension pour laquelle l'état de charge d'une cellule est de 0%) et $V_{seuil\ haut}$ est le seuil d'utilisation maximum (valeur de tension pour laquelle l'état de charge d'une cellule est de 100%).

Cette équation peut également être écrite sous la forme suivante, faisant mieux apparaître les éléments de pondération $\alpha(k)$ et $(1-\alpha(k))$ indiqués ci-avant :

$$U_{mp}(k) = \alpha(k) \cdot U_{Cmin}(k) + (1 - \alpha(k)) \cdot U_{Cmax}(k) \qquad (1)$$

Avec

$$\alpha(k) = \frac{V_{seuil\ haut} - U_{Cmax}(k)}{\left(V_{seuil\ haut} - V_{seuil\ bas}\right) - \left(U_{Cmax}(k) - U_{Cmin}(k)\right)}$$

et

$$\left(1 - \alpha(k)\right) = -\frac{V_{seuil\ bas} - U_{Cmin}(k)}{\left(V_{seuil\ haut} - V_{seuil\ bas}\right) - \left(U_{Cmax}(k) - U_{Cmin}(k)\right)}$$

Comme représenté sur la figure 3, un dispositif d'estimation conforme à l'invention comporte un premier module 3 relié à chaque borne des cellules $C_1$ à $C_N$ composant la batterie, apte à délivrer les tensions de cellule minimum $U_{Cmin}$ et maximum $U_{Cmax}$, de préférence sous forme d'échantillons $U_{Cmin}(k)$ et $U_{Cmax}(k)$ à des instants k donnés. Le premier module 3 est de préférence un composant apte à réaliser la fonction MIN-MAX, c'est-à-dire à déterminer et délivrer directement à une unité de contrôle électronique 4 du dispositif les deux valeurs $U_{Cmin}(k)$ et $U_{Cmax}(k)$ sans qu'il soit nécessaire de mesurer les N tensions de cellule. Un module de calcul 40 dans l'unité de contrôle électronique 4 calcule alors la tension moyenne pondérée $U_{mp}$ en appliquant l'équation (1) ci-dessus.

Le dispositif comporte en outre un capteur de courant (non représenté) apte à fournir une mesure $I_{BAT}$ du courant de la batterie et un capteur de température (non représenté) apte à fournir une mesure $T_{BAT}$ de la température de la batterie.

Un module d'estimation 41 dans l'unité de contrôle électronique 4 reçoit d'une part, la tension moyenne pondérée $U_{mp}$, et d'autre part, le courant $I_{BAT}$ et la température $T_{BAT}$ mesurés, et calcule une estimation de l'état de charge de la batterie $SOC_{BAT}$ à partir de ces trois valeurs.

Bien que d'autres algorithmes soient utilisables, le module d'estimation 41 implémente de préférence une méthode de filtrage de type Kalman, qui va à présent être explicitée:

Le comportement électrique de la batterie est décrit par un modèle du type « circuit électrique équivalent », donné en figure 4. La batterie est ici représentée comme une cellule, dont la tension moyenne pondérée $U_{mp}$ est la tension en circuit fermé, et où : $OCV$ est la tension à vide, $I_{BAT}$ est le courant traversant la batterie, $R_1$ correspond à la résistance interne moyenne d'une cellule, $R_2$ et $C_2$ sont une résistance et une capacité (moyennes d'une cellule) utilisées pour modéliser des phénomènes dynamiques et $U_{C2}$ est la tension de la paire $R_2//C_2$. La tension à vide $OCV$ est une fonction non-linéaire de l'état de charge, différente pour chaque chimie de batterie. Il est possible de faire une approximation affine par morceaux de cette courbe, cette à dire, une approximation du type $OCV(\theta)=a\theta+b$, ce qui est utilisé dans la suite.

Par ailleurs, l'évolution de l'état de charge de la batterie entre deux échantillons successifs séparés de la période d'échantillonnage $T_e$ est donnée par l'expression :

$$SOC_{BAT}(k) = SOC_{BAT}(k-1) + \frac{T_e}{Q_{max}} I_{BAT}(k-1)$$

où $Q_{max}$ est la capacité en Ah (Ampère-heure) de la batterie.

Par combinaison du modèle du comportement électrique avec l'évolution de l'état de charge de la batterie, on obtient le modèle mathématique donné par le système d'équations:

$$\begin{cases} x(k+1) = A_s x(k) + B_s u(k) \\ y(k) = C_s x(k) + D_s u(k) \end{cases}$$

avec

un vecteur d'état $x(k) = \begin{bmatrix} SOC_{BAT}(k) \\ U_{C2}(k) \end{bmatrix}$,

un vecteur de sortie $y(k)=U_{mp}(k)-b$,

un vecteur de commande $u(k)=I_{BAT}(k)$ et

des matrices $A_s = \begin{bmatrix} 1 & 0 \\ 0 & \left(1-\dfrac{T_e}{R_2 C_2}\right) \end{bmatrix}$, $B_s = \begin{bmatrix} \dfrac{T_e}{Q_{\max}} \\ \dfrac{T_e}{C_2} \end{bmatrix}$, $C_s=[a\ 1]$, $D_s=R_1$

A noter que les matrices de transition $A_s$, de commande $B_s$ et de lien entre commande et sortie $D_s$ sont mises à jour à chaque pas de calcul, puisqu'elles dépendent des paramètres $R_1$, $R_2$ et $C_2$, qui varient eux-mêmes en fonction de la température, de l'état de charge (et éventuellement de l'état de santé SOH).

Le filtrage de Kalman consiste alors classiquement à :

(a) Prédire l'état et la sortie en utilisant les équations suivantes :

$$\hat{x}_{k\|k-1} = A_s \hat{x}_{k-1\|k-1} + B_s u_{k-1}$$

$$\hat{y}_{k\|k-1} = C_s \hat{x}_{k-1\|k-1} + D_s u_{k-1}$$

(b) Calculer le gain optimal $K_k$ du filtre:

$$K_k = P_{k\|k-1} C_s{}^T \left( C_s P_{k\|k-1} C_s{}^T + R_{kal} \right)^{-1}$$

avec

$$P_{k\|k-1} = A_s P_{k-1\|k-1} A_s{}^T + Q_{kal}$$

$$P_{k\|k} = P_{k\|k-1} - K_k \left( C_s P_{k\|k-1} C_s{}^T + R_{kal} \right) K_k^T$$

où $Q_{kal}$ et $R_{kal}$ correspondent respectivement à la variance de l'état et à la variance de la sortie.

(c) Corriger l'état prédit par réinjection de l'erreur sur la sortie estimée :

$$\hat{x}_{k\|k} = \hat{x}_{k\|k-1} + K_k \left( y_k - \hat{y}_{k\|k-1} \right)$$

L'état de charge de la batterie est donné par le résultat de l'estimateur, selon la relation

$$SOC_{BAT}(k) = \begin{bmatrix} 1 & 0 \end{bmatrix} \cdot \hat{x}_{k\|k}$$

Un exemple des résultats obtenus en appliquant l'estimateur précédent pour un cycle de conduite, est montré en figure 5. Pour ce test, une batterie composée de 12 cellules a été utilisée, avec une dispersion de +/- 5% sur les états de charge des cellules. La figure illustre en trait foncé l'évolution temporelle de l'état de charge estimé de la batterie, et en traits plus clairs, les évolutions des états de charge des différentes cellules. On constate sur cette figure 5 que l'évolution temporelle de l'état de charge de la batterie est conforme aux attentes. En effet, l'état de charge de la batterie est à 100% lorsque la cellule la plus chargée présente également un état de charge de 100%, et l'état de charge de la batterie est à 0% lorsque la cellule la moins chargée présente également un état de charge de 0%. Entre ces deux valeurs, l'état de charge décroît de façon continue, sans variations abruptes.

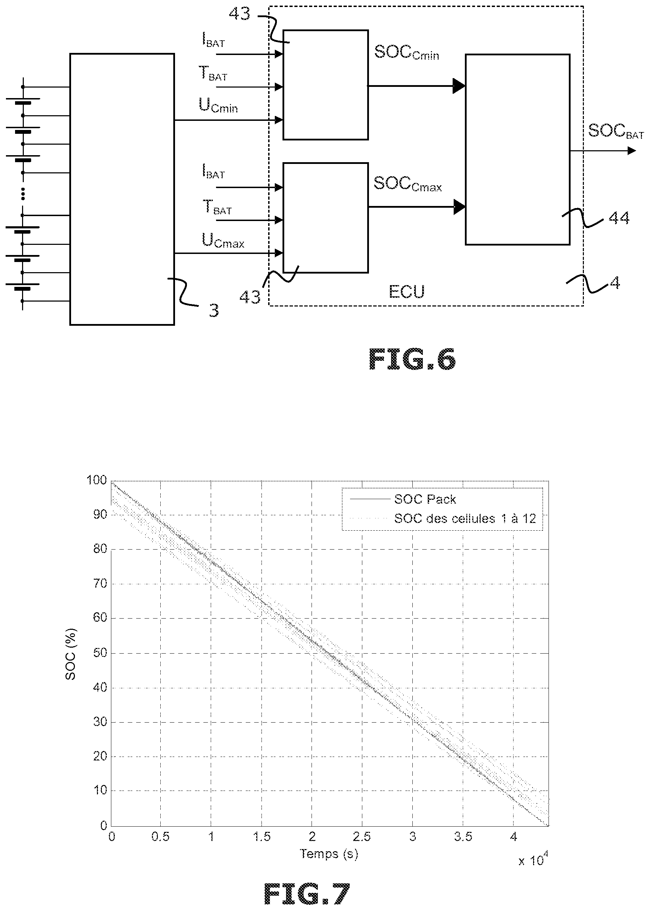

La figure 6 illustre schématiquement un second dispositif conforme à la présente invention. Ici, la grandeur physique à laquelle on s'intéresse est directement l'état de charge de la batterie $SOC_{BAT}$. Comme dans le cas représenté sur la figure 3, le dispositif comporte une premier module 3 relié à chaque borne des cellules $C_1$ à $C_N$ composant la batterie, apte à délivrer les tensions de cellule minimum $U_{Cmin}$ et maximum $U_{Cmax}$, de préférence sous forme d'échantillons $U_{Cmin}(k)$ et $U_{Cmax}(k)$ à des instants k donnés. Ici encore, ce premier module 3 est de préférence un composant apte à réaliser la fonction MIN-MAX, c'est-à-dire à déterminer et délivrer directement à une unité de contrôle électronique 4 du dispositif les deux valeurs $U_{Cmin}(k)$ et $U_{Cmax}(k)$ sans qu'il soit nécessaire de mesurer les N tensions de cellule.

Le dispositif comporte en outre un capteur de courant (non représenté) apte à fournir une mesure $I_{BAT}$ du courant de la batterie et un capteur de température (non représenté) apte à fournir une mesure $T_{BAT}$ de la température de la batterie.

A la différence du dispositif de la figure 3, l'unité de contrôle électronique 4 comporte ici deux modules d'estimation 43 :

- un premier module connecté à celle des deux sorties du premier module 3 délivrant la tension de cellule minimum $U_{Cmin}$, ce premier module étant apte à délivrer une estimation $SOC_{Cmin}$ de l'état de charge de la cellule la moins chargée à partir des valeurs $U_{Cmin}$, $I_{BAT}$ et $T_{BAT}$.
- un deuxième module connecté à celle des deux sorties du premier module 3 délivrant la tension de cellule maximum $U_{Cmax}$, ce deuxième module étant apte à délivrer une estimation $SOC_{Cmax}$ de l'état de charge de la cellule la plus chargée à partir des valeurs $U_{Cmax}$, $I_{BAT}$ et $T_{BAT}$.

Les deux modules d'estimation 43 délivrent à chaque instant d'échantillonnage k deux échantillons $SOC_{Cmin}(k)$ et $SOC_{Cmax}(k)$, estimés par toute méthode connue, telle que la méthode de filtrage de type Kalman explicitée ci-avant.

Un module de calcul 44 l'unité de contrôle électronique 4 calcule alors l'état de charge $SOC_{BAT}(k)$ de la batterie, par pondération des états de charge des deux cellules les plus et les moins chargées selon la relation :

$$SOC_{BAT}(k) = \frac{SOC_{seuil\ haut}\,SOC_{Cmin}(k) - SOC_{seuil\ bas}\,SOC_{Cmax}(k)}{\left(SOC_{seuil\ haut} - SOC_{seuil\ bas}\right) - \left(SOC_{Cmax}(k) - SOC_{Cmin}(k)\right)}$$

dans laquelle $SOC_{seuil\ haut}$ est l'état de charge égal à 1 d'une cellule dont la tension de cellule correspond au seuil d'utilisation maximum défini précédemment, et $SOC_{seuil\ bas}$ est l'état de charge égal à 0 d'une cellule dont la tension de cellule correspond au seuil d'utilisation minimum défini précédemment.

Soit :

$$SOC_{BAT}(k) = \delta(k))SOC_{Cmin}(k) + (1 - \delta(k))SOC_{Cmax}(k)$$

avec

$$\delta(k) = \frac{SOC_{seuil\ haut} - SOC_{Cmax}(k)}{\left(SOC_{seuil\ haut} - SOC_{seuil\ bas}\right) - \left(SOC_{Cmax}(k) - SOC_{Cmin}(k)\right)}$$

et

$$(1 - \delta(k)) = -\frac{SOC_{seuil\ bas} - SOC_{Cmin}(k)}{\left(SOC_{seuil\ haut} - SOC_{seuil\ bas}\right) - \left(SOC_{Cmax}(k) - SOC_{Cmin}(k)\right)}$$

Comme $SOC_{seuil\ haut} = 1$ et $SOC_{seuil\ bas} = 0$, on arrive à la formule simplifiée suivante

$$SOC_{BAT}(k) = \frac{SOC_{Cmin}(k)}{1 - \left(SOC_{Cmax}(k) - SOC_{Cmin}(k)\right)}$$

Un exemple des résultats obtenus en appliquant l'estimateur précédent pour un cycle de conduite, est montré en figure 7. Pour ce test, une batterie composée de 12 cellules a été utilisée, avec une dispersion de +/- 5% sur les états de charge des cellules. La figure illustre en trait foncé l'évolution temporelle de l'état de charge estimé de la batterie, et entraits plus clairs, les évolutions des états de charge des différentes cellules. On constate ici encore que l'évolution temporelle de l'état de charge de la batterie est conforme aux attentes, avec un état de charge de la batterie de 100% lorsque la cellule la plus chargée présente également un état de charge de 100%, un état de charge de la batterie de 0% lorsque la cellule la moins chargée présente également un état de charge de 0%, et une décroissance continue, sans variations abruptes, de l'état de charge entre ces deux valeurs extrêmes.

Le dispositif selon la figure 6 demande une puissance de calcul légèrement supérieure à celle nécessitée pour le dispositif de la figure 3, mais présente l'avantage d'être insensible au comportement non-linéaire de la tension à vide de la batterie.

L'estimation du dispositif selon la figure 6 peut encore être affinée dans le cas où le premier module 3 est capable d'identifier les deux cellules qui présentent les valeurs $U_{Cmin}$ et $U_{Cmax}$. Une meilleure estimation des valeurs $SOC_{Cmin}$ et $SOC_{C\,max}$ peut alors être faite par les modules 43 en prenant en compte la température au voisinage des deux cellules identifiées, et en utilisant les paramètres propres à ces cellules (notamment leur capacité Qmax et leur état de santé SOH).

Dans tous les cas exposés ci-dessus, les dispositifs d'estimation conformes à l'invention ont une précision comparable à celui illustré en figure 2, tout en nécessitant moins de puissance de calcul. Le coût total du dispositif peut en outre être encore réduit si le module 3 utilisé est capable de délivrer directement les mesures $U_{Cmin}$ et $U_{Cmax}$ sans qu'il soit nécessaire de mesurer toutes les tensions de cellule.

## Revendications

1. Méthode d'estimation de l'état de charge ($SOC_{BAT}$) d'une batterie comportant plusieurs cellules ($C_1,...C_N$) électro-chimiques connectées en série, la tension aux bornes de la batterie correspondant à la somme des tensions aux bornes de chaque cellule appelées tensions de cellule, **caractérisée en ce qu'**elle comporte les étapes suivantes:

   - détermination à un instant donné de la tension de cellule minimum ($U_{Cmin}$) et de la tension de cellule maximum ($U_{Cmax}$) parmi lesdites tensions de cellule;
   - à partir des tensions de cellule minimum et maximum déterminées à l'étape précédente, calcul d'une grandeur physique ($U_{mp}$ ; $SOC_{BAT}$) égale à l'état de charge ($SOC_{BAT}$) de la batterie ou dont dépend directement ou indirectement l'état de charge ($SOC_{BAT}$) de la batterie, ladite grandeur physique dépendant analytiquement directement ou indirectement de ladite tension de cellule minimum ($U_{Cmin}$) et de ladite tension de cellule maximum ($U_{Cmax}$) selon une équation incluant des éléments de pondération assurant que le poids associé à la tension de cellule maximum ($U_{Cmax}$) augmente lorsque l'état de charge de la cellule associée augmente, et le poids associé à la tension de cellule minimum ($U_{Cmin}$) augmente lorsque l'état de charge de la cellule associée diminue.

2. Méthode d'estimation selon la revendication 1, **caractérisée en ce que** ladite grandeur physique est une tension moyenne pondérée dépendant analytiquement de ladite tension de cellule minimum ($U_{Cmin}$) et de ladite tension de cellule maximum ($U_{Cmax}$) selon l'équation suivante :

$$U_{mp}(k) = \frac{V_{seuil\,haut}U_{Cmin}(k) - V_{seuil\,bas}U_{Cmax}(k)}{\left(V_{seuil\,haut} - V_{seuil\,bas}\right) - \left(U_{Cmax}(k) - U_{Cmin}(k)\right)}$$

   où $U_{Cmin}(k)$ et $U_{Cmax}(k)$ sont respectivement des échantillons de la tension de cellule minimum et la tension de cellule maximum à l'instant donné k, $V_{seuil\,bas}$ est un seuil de tension minimum d'utilisation prédéterminé correspondant à un état de charge minimum de la cellule associée et $V_{seuil\,haut}$ est un seuil de tension maximum d'utilisation prédéterminé correspondant à un état de charge maximum de la cellule associée.

3. Méthode d'estimation selon la revendication 2, **caractérisée en ce qu'**elle comporte en outre une étape d'estimation de l'état de charge ($SOC_{BAT}$) de la batterie à partir de ladite tension moyenne, d'une mesure du courant traversant les cellules audit instant donné, et d'une mesure de température de la batterie audit instant donné.

4. Méthode d'estimation selon la revendication 3, **caractérisée en ce que** ladite étape d'estimation comprend un filtrage de type Kalman.

**5.** Méthode d'estimation selon la revendication 1, **caractérisée en ce qu'**elle comporte en outre :

- une première estimation de l'état de charge $SOC_{Cmin}(k)$ de la cellule associée à la tension de cellule minimum ($U_{Cmin}$) à partir de ladite tension de cellule minimum ($U_{Cmin}$), d'une mesure du courant traversant les cellules audit instant donné, et d'une première mesure de température audit instant donné ; et

- une deuxième estimation de l'état de charge $SOC_{Cmax}(k)$ de la cellule associée à la tension de cellule maximum ($U_{Cmax}$) à partir de ladite tension de cellule maximum ($U_{Cmax}$), de ladite mesure de courant traversant les cellules audit instant donné, et d'une deuxième mesure de température audit instant donné ;

et **en ce que** ladite grandeur physique est directement l'état de charge ($SOC_{BAT}$) de la batterie audit instant donné, calculé selon l'équation

$$SOC_{BAT}(k) = \frac{SOC_{Cmin}(k)}{1 - (SOC_{Cmax}(k) - SOC_{Cmin}(k))}$$

**6.** Méthode d'estimation selon la revendication 5, **caractérisée en ce que** lesdites première et deuxième estimations comprennent un filtrage de type Kalman.

**7.** Méthode d'estimation selon l'une quelconque des revendications 5 ou 6, **caractérisée en ce que** lesdites première et deuxième mesures de température sont une même mesure représentative de la température de la batterie.

**8.** Méthode d'estimation selon l'une quelconque des revendications 5 ou 6, **caractérisée en ce que** lesdites première et deuxième mesures de température sont deux mesures distinctes prises respectivement au voisinage de la cellule associée à la tension de cellule minimum ($U_{Cmin}$) et au voisinage de la cellule associée à la tension de cellule maximum ($U_{Cmax}$).

**9.** Dispositif d'estimation de l'état de charge ($SOC_{BAT}$) d'une batterie comportant plusieurs cellules ($C_1,...C_N$) électrochimiques connectées en série, la tension aux bornes de la batterie correspondant à la somme des tensions aux bornes de chaque cellule appelées tensions de cellule, **caractérisé en ce qu'**il comporte :

- un moyen (3) de détermination à un instant donné de la tension de cellule minimum ($U_{Cmin}$) et de la tension de cellule maximum ($U_{Cmax}$) parmi lesdites tensions de cellule;

- des moyens (4, 40-41 ; 4, 43-44) de calcul, à partir des tensions de cellule minimum et maximum délivrées par le moyen de détermination, d'une grandeur physique ($U_{mp}$ ; $SOC_{BAT}$) égales à l'état de charge ($SOC_{BAT}$) de la batterie ou dont dépend directement ou indirectement l'état de charge ($SOC_{BAT}$) de la batterie, ladite grandeur physique dépendant analytiquement directement ou indirectement de ladite tension de cellule minimum ($U_{Cmin}$) et de ladite tension de cellule maximum ($U_{Cmax}$) selon une équation incluant des éléments de pondération assurant que le poids associé à la tension de cellule maximum ($U_{Cmax}$) augmente lorsque l'état de charge de la cellule associée augmente, et le poids associé à la tension de cellule minimum ($U_{Cmin}$) augmente lorsque l'état de charge de la cellule associée diminue.

**10.** Dispositif d'estimation selon la revendication 9, **caractérisé en ce que** le moyen (3) de détermination est un composant analogique doté d'une fonction MIN-MAX.

**Patentansprüche**

**1.** Verfahren zur Schätzung des Ladezustands ($SOC_{BAT}$) einer Batterie, die mehrere elektrochemische Zellen ($C_1,...C_N$) aufweist, die in Reihe geschaltet sind, wobei die Spannung an den Anschlüssen der Batterie der Summe der Spannungen an den Anschlüssen jeder Zelle entspricht, die als Zellenspannungen bezeichnet werden, **dadurch gekennzeichnet, dass** es die folgenden Schritte aufweist:

- Bestimmen, zu einem bestimmten Zeitpunkt, der minimalen Zellenspannung ($U_{Cmin}$) und der maximalen Zellenspannung ($U_{Cmax}$) von den Zellenspannungen;

- Berechnen, anhand der minimalen und der maximalen Zellenspannung, die im vorhergehenden Schritt bestimmt wurden, einer physikalischen Größe, ($U_{mp}$ ; $SOC_{BAT}$), die gleich dem Ladezustand ($SOC_{BAT}$) der Batterie ist, oder von der direkt oder indirekt der Ladezustand ($SOC_{BAT}$) der Batterie abhängt, wobei die physikalische Größe analytisch direkt oder indirekt von der minimalen Zellenspannung ($U_{Cmin}$) und der maximalen Zellenspannung ($U_{Cmax}$) gemäß einer Gleichung abhängt, die Gewichtungselemente enthält, die sicherstellen, dass das Gewicht, das mit der maximalen Zellenspannung ($U_{Cmax}$) in Verbindung steht, zunimmt, wenn der Ladezustand der zugehörigen Zelle zunimmt, und das Gewicht, das mit der minimalen Zellenspannung ($U_{Cmin}$) in Verbindung steht, zunimmt, wenn der Ladezustand der zugehörigen Zelle abnimmt.

2. Verfahren zur Schätzung nach Anspruch 1, **dadurch gekennzeichnet, dass** die physikalische Größe eine gewichtete mittlere Spannung ist, die gemäß der folgenden Gleichung analytisch von der minimalen Zellenspannung ($U_{Cmin}$) und von der maximalen Zellenspannung ($U_{Cmax}$) abhängt:

$$U_{mp}(k) = \frac{V_{obere\ Schwelle} U_{Cmin}(k) - V_{untere\ Schwelle} U_{Cmax}(k)}{(V_{obere\ Schwelle} - V_{untere\ Schwelle}) - (U_{Cmax}(k) - U_{Cmin}(k))}$$

wobei $U_{Cmin}(k)$ und $U_{Cmax}(k)$ jeweils Abtastwerte der minimalen Zellenspannung und der maximalen Zellenspannung zu dem bestimmten Zeitpunkt k sind, $V_{untere\ Schwelle}$ eine vorbestimmte minimale Betriebsspannungsschwelle ist, die einem minimalen Ladezustand der zugehörigen Zelle entspricht, und $V_{obere\ Schwelle}$ eine vorbestimmte maximale Betriebsspannungsschwelle ist, die einem maximalen Ladezustand der zugehörigen Zelle entspricht.

3. Verfahren zur Schätzung nach Anspruch 2, **dadurch gekennzeichnet, dass** es ferner einen Schritt des Schätzens des Ladezustands ($SOC_{BAT}$) der Batterie anhand der mittleren Spannung, einer Messung des Stroms, der die Zellen zu dem bestimmten Zeitpunkt durchläuft, und einer Temperaturmessung der Batterie zu dem bestimmten Zeitpunkt aufweist.

4. Verfahren zur Schätzung nach Anspruch 3, **dadurch gekennzeichnet, dass** der Schritt des Schätzens eine Kalman-Filterung umfasst.

5. Verfahren zur Schätzung nach Anspruch 1, **dadurch gekennzeichnet, dass** es ferner Folgendes aufweist:

   - ein erstes Schätzen des Ladezustands $SOC_{Cmin}(k)$ der Zelle, die mit der minimalen Zellenspannung ($U_{Cmin}$) in Verbindung steht, anhand der minimalen Zellenspannung ($U_{Cmin}$), einer Messung des Stroms, der die Zellen zu dem bestimmten Zeitpunkt durchläuft, und einer ersten Temperaturmessung zu dem bestimmten Zeitpunkt; und
   - ein zweites Schätzen des Ladezustands $SOC_{Cmax}(k)$ der Zelle, die mit der maximalen Zellenspannung ($U_{Cmax}$) in Verbindung steht, anhand der maximalen Zellenspannung ($U_{Cmax}$), der Messung von Strom, der die Zellen zu dem bestimmten Zeitpunkt durchläuft, und einer zweiten Temperaturmessung zu dem bestimmten Zeitpunkt; und dadurch, dass die physikalische Größe direkt der Ladezustand ($SOC_{BAT}$) der Batterie zu dem bestimmten Zeitpunkt ist, der gemäß folgender Gleichung berechnet wird:

$$SOC_{BAT}(k) = \frac{SOC_{Cmin}(k)}{1 - (SOC_{Cmax}(k) - SOC_{Cmin}(k))}$$

6. Verfahren zur Schätzung nach Anspruch 5, **dadurch gekennzeichnet, dass** die erste und die zweite Schätzung eine Kalman-Filterung umfassen.

7. Verfahren zur Schätzung nach einem der Ansprüche 5 oder 6, **dadurch gekennzeichnet, dass** die erste und die zweite Temperaturmessung eine selbe repräsentative Messung der Temperatur der Batterie sind.

8. Verfahren zur Schätzung nach einem der Ansprüche 5 oder 6, **dadurch gekennzeichnet, dass** die erste und die zweite Temperaturmessung zwei verschiedene Messungen sind, die jeweils in der Umgebung der Zelle, die mit der minimalen Zellenspannung ($U_{Cmin}$) in Verbindung steht, und in der Umgebung der Zelle, die mit der maximalen Zellenspannung ($U_{Cmax}$) in Verbindung steht, vorgenommen werden.

9. Vorrichtung zur Schätzung des Ladezustands ($SOC_{BAT}$) einer Batterie, die mehrere elektrochemische Zellen ($C_1,...C_N$) aufweist, die in Reihe geschaltet sind, wobei die Spannung an den Anschlüssen der Batterie der Summe der Spannungen an den Anschlüssen jeder Zelle entspricht, die als Zellenspannungen bezeichnet werden, **dadurch gekennzeichnet, dass** sie Folgendes aufweist:

- ein Mittel (3) zum Bestimmen, zu einem bestimmten Zeitpunkt, der minimalen Zellenspannung ($U_{Cmin}$) und der maximalen Zellenspannung ($U_{Cmax}$) von den Zellenspannungen;
- Mittel (4, 40-41; 4, 43-44) zum Berechnen, anhand der minimalen und der maximalen Zellenspannung, die vom Mittel zum Bestimmen geliefert werden, einer physikalischen Größe, ($U_{mp}$; $SOC_{BAT}$), die gleich dem Ladezustand ($SOC_{BAT}$) der Batterie ist, oder von der direkt oder indirekt der Ladezustand ($SOC_{BAT}$) der Batterie abhängt, wobei die physikalische Größe analytisch direkt oder indirekt von der minimalen Zellenspannung ($U_{Cmin}$) und der maximalen Zellenspannung ($U_{Cmax}$) gemäß einer Gleichung abhängt, die Gewichtungselemente enthält, die sicherstellen, dass das Gewicht, das mit der maximalen Zellenspannung ($U_{Cmax}$) in Verbindung steht, zunimmt, wenn der Ladezustand der zugehörigen Zelle zunimmt, und das Gewicht, das mit der minimalen Zellenspannung ($U_{Cmin}$) in Verbindung steht, zunimmt, wenn der Ladezustand der zugehörigen Zelle abnimmt.

**10.** Vorrichtung zur Schätzung nach Anspruch 9, **dadurch gekennzeichnet, dass** das Mittel (3) zum Bestimmen eine analoge Komponente ist, die mit einer MIN-MAX-Funktion versehen ist.

**Claims**

**1.** Method for estimating the state of charge ($SOC_{BAT}$) of a battery comprising several electrochemical cells ($C_1,...C_N$) connected in series, the voltage across the terminals of the battery corresponding to the sum of the voltages across the terminals of each cell, called cell voltages, **characterized in that** it comprises the following steps:

- determining, at a given moment in time, the minimum cell voltage ($U_{Cmin}$) and the maximum cell voltage ($U_{Cmax}$) from amongst said cell voltages;
- on the basis of the minimum and maximum cell voltages determined in the preceding step, calculating a physical quantity ($U_{mp}$ ; $SOC_{BAT}$) equal to the state of charge ($SOC_{BAT}$) of the battery or on which the state of charge ($SOC_{BAT}$) of the battery directly or indirectly depends, said physical quantity depending analytically, directly or indirectly, on said minimum cell voltage ($U_{Cmin}$) and on said maximum cell voltage ($U_{Cmax}$) according to an equation including weighting elements ensuring that the weighting associated with the maximum cell voltage ($U_{Cmax}$) increases when the state of charge of the associated cell increases, and the weighting associated with the minimum cell voltage ($U_{Cmin}$) increases when the state of charge of the associated cell decreases.

**2.** Estimation method according to Claim 1, **characterized in that** said physical quantity is a weighted mean voltage depending analytically on said minimum cell voltage ($U_{Cmin}$) and on said maximum cell voltage ($U_{Cmax}$) according to the following equation:

$$U_{mp}(k) = \frac{V_{high\_threshold} U_{Cmin}(k) - V_{low\_threshold} U_{Cmax}(k)}{\left(V_{high\_threshold} - V_{low\_threshold}\right) - \left(U_{Cmax}(k) - U_{Cmin}(k)\right)}$$

where $U_{Cmin}(k)$ and $U_{Cmax}(k)$ are respectively samples of the minimum cell voltage and the maximum cell voltage at the given moment in time k, $V_{low\_threshold}$ is a predetermined minimum voltage threshold in use corresponding to a minimum state of charge of the associated cell and $V_{high\_threshold}$ is a predetermined maximum voltage threshold in use corresponding to a maximum state of charge of the associated cell.

**3.** Estimation method according to Claim 2, **characterized in that** it furthermore comprises a step for estimating the state of charge ($SOC_{BAT}$) of the battery from said mean voltage, for measuring the current flowing through the cells at said moment in time, and for measuring the temperature of the battery at said moment in time.

**4.** Estimation method according to Claim 3, **characterized in that** said estimation step comprises a filtering of the Kalman type.

**5.** Estimation method according to Claim 1, **characterized in that** it furthermore comprises:

- a first estimation of the state of charge $SOC_{Cmin}(k)$ of the cell associated with the minimum cell voltage ($U_{Cmin}$)

using said minimum cell voltage ($U_{Cmin}$), a measurement of the current flowing through the cells at said moment in time, and a first measurement of temperature at said moment in time; and
- a second estimation of the state of charge $SOC_{Cmax}(k)$ of the cell associated with the maximum cell voltage ($U_{Cmax}$) using said maximum cell voltage ($U_{Cmax}$), said measurement of current flowing through the cells at said moment in time, and a second measurement of temperature at said moment in time;
and **in that** said physical quantity is directly the state of charge ($SOC_{BAT}$) of the battery at said moment in time, calculated according to the equation

$$SOC_{BAT}(k) = \frac{SOC_{Cmin}(k)}{1 - \left(SOC_{Cmax}(k) - SOC_{Cmin}(k)\right)}$$

6. Estimation method according to Claim 5, **characterized in that** said first and second estimations comprise a filtering of the Kalman type.

7. Estimation method according to either one of Claims 5 and 6, **characterized in that** said first and second measurements of temperature are one and the same measurement representative of the temperature of the battery.

8. Estimation method according to either one of Claims 5 and 6, **characterized in that** said first and second measurements of temperature are two different measurements respectively taken in the neighborhood of the cell associated with the minimum cell voltage ($U_{Cmin}$) and in the neighborhood of the cell associated with the maximum cell voltage ($U_{Cmax}$).

9. Device for estimating the state of charge ($SOC_{BAT}$) of a battery comprising several electrochemical cells ($C_1,...C_N$) connected in series, the voltage across the terminals of the battery corresponding to the sum of the voltages across the terminals of each cell, called cell voltages, **characterized in that** it comprises:

- a means (3) for determining, at a given moment in time, the minimum cell voltage ($U_{Cmin}$) and the maximum cell voltage ($U_{Cmax}$) from amongst said cell voltages;
- a means (4, 40-41; 4, 43-44) for calculating, on the basis of the minimum and maximum cell voltages delivered by the determination means, a physical quantity ($U_{mp}$ ; $SOC_{BAT}$) equal to the state of charge ($SOC_{BAT}$) of the battery or on which the state of charge ($SOC_{BAT}$) of the battery directly or indirectly depends, said physical quantity depending analytically, directly or indirectly, on said minimum cell voltage ($U_{Cmin}$) and on said maximum cell voltage ($U_{Cmax}$) according to an equation including weighting elements ensuring that the weighting associated with the maximum cell voltage ($U_{Cmax}$) increases when the state of charge of the associated cell increases, and the weighting associated with the minimum cell voltage ($U_{Cmin}$) increases when the state of charge of the associated cell decreases.

10. Estimation device according to Claim 9, **characterized in that** the determination means (3) is an analog component performing a MIN-MAX function.

**FIG.1**

**FIG.2**

**FIG.3**

**FIG.4**

**FIG.5**

**FIG.6**

**FIG.7**

**EP 2 847 603 B1**